# EUROPEAN PATENT SPECIFICATION

(11) **EP 3 250 459 B1**
(45) Date of publication and mention of the grant of the patent: **04.09.2019**
(21) Application number: 16702449.6
(22) Date of filing: 20.01.2016
(51) Int. Cl.: B64D 45/02, B64C 1/18, F16J 15/06, F16J 15/12

(54) **CONDUCTIVE SEALING MEMBER**
LEITENDES DICHTUNGSELEMENT
ÉLÉMENT D'ÉTANCHÉITÉ CONDUCTEUR

(30) Priority: 30.01.2015 US 201562109792 P
(43) Date of publication of application: 06.12.2017
(73) Proprietor: Bombardier Inc., Dorval QC H4S1Y9 (CA); Short Brothers Plc, Belfast, Antrim BT3 9DZ (GB)
(72) Inventor: ROBOREL DE CLIMENS, Lody, Montréal, Québec H2W 1M7 (CA); DESY, Philippe, Prévost, Québec J0R 1T0 (CA); KOHLER, Johan, Salaberry-de-Valleyfield, Québec J6T 2T3 (CA)
(74) Representative: HGF Limited
(86) International application number: PCT/IB2016/050275
(87) International publication number: WO 2016/120755

(56) References cited:
- EP-A2- 0 275 171
- WO-A2-2008/008255
- WO-A2-2014/135943
- US-A1- 2014 246 112
- US-A1- 2014 360 772

## Description

### FIELD OF THE APPLICATION

The application relates generally to electrical grounding and moisture sealing in aircraft and, more particularly, to a conductive sealant for sealing a connection between two aircraft components while allowing conductivity at the connection. More specifically the application pertains a grounded floor assembly for an aircraft.

### BACKGROUND OF THE ART

A known way to provide electrical protection for aircraft wires and wire bundles is to position the wires near a grounded, electrically conductive substrate. Typically, the substrate is made from metal, such as a metallic fuselage skin, because metal materials are excellent conductors. In addition, metal materials function well to protect electrical signals in wires from being influenced by EM and RF interference.

When the fuselage skin is made of a material which is not sufficiently conductive (e.g. composite material), the wires may be placed adjacent a ground plane under floor panels to offer the adequate protection to the wires against the EM and RF interference, for example because of space requirements. Aircraft floor panels containing a ground plane typically include a metal to metal connection with the supporting floor beams to provide a bonding interface in order for the ground plane to be effective. The floor beam/floor panel interfaces usually require sealing to prevent water or other fluids from leaking under the floor panels, such as to mitigate the risks of corrosion.

One known method of floor panel assembly, known from WO2014/135943A, includes providing seals at the floor beam/floor panel interfaces and grounding the floor panels through metal brackets interconnecting the floor beams and floor panels on each side of the sealed connection. However, installation or replacement of such brackets may be difficult and/or time consuming, and/or the brackets may be damaged during installation and maintenance. A prior art deflectable conductive gasket with environmental seal is known from US2014/360772A.

Other sealingly connected elements of aircraft also require conduction therebetween, for example for grounding purposes.

### SUMMARY OF THE APPLICATION

In one example useful for understanding the invention, there is provided a sealing member for a connection between two aircraft components, the sealing member comprising: a body having first and second opposed contact surfaces each contacting a respective one of the two aircraft components, and first and second opposed side surfaces extending between and interconnecting the contact surfaces, the body having a thickness defined between the contact surfaces and a width defined between the side surfaces, the body including: a conductive portion extending across the thickness of the body and defining part of each of the contact surfaces, the conductive portion extending along the width of the body from a first location to a second location, the first and second locations being inwardly spaced with respect to the first and second side surfaces; a first sealing portion extending across the thickness of the body and defining the first side surface, the first sealing portion extending along the width of the body from the first side surface to the conductive portion, the first sealing portion defining part of each of the contact surfaces from the first side surface to the conductive portion; and a second sealing portion extending across the thickness of the body and defining the second side surface, the second sealing portion extending along the width of the body from the second side surface to the conductive portion, the second sealing portion defining part of each of the contact surfaces from the second side surface to the conductive portion; wherein the conductive portion is more conductive than the first and second sealing portions; and wherein the first and second sealing portions are made of a sealing material.

In a particular example, the contact surfaces are covered by an adhesive. The adhesive may be releasably engaged to a respective backing paper covering each contact surface.

In another example, there is provided a sealed component assembly within an aircraft, comprising: first and second components each having a surface, the surfaces of the first and second components facing one another; a sealing member extending between the facing surfaces of the first and second components, the sealing member including a conductive portion sandwiched between first and second sealing portions. with: the first and second sealing portions extending between and in contact with the facing surfaces of the first and second components, the first and second sealing portions being made of a sealing material; and the conductive portion in contact with conductive regions of the facing surfaces of the first and second components and defining an electrical connection therebetween, the conductive portion being more conductive than the first and second sealing portions.

In a particular example, the first and second components are connected by fasteners extending through one or both of the first and second sealing portions.

In a particular example, the first component is a floor panel with a ground plane defining the conductive surface of the floor panel, and the second component is a floor beam supporting the floor panel.

According to the invention, as per claim 1, there is provided a grounded floor assembly for an aircraft, the assembly comprising: a floor panel having a bottom surface; a conductive floor beam supporting and connected to the floor panel; a sealing member between the floor panel and the floor beam, the sealing member including a conductive portion sandwiched between first and second sealing portions; wherein: the first and second sealing portions extend between and in contact with the bottom surface of the floor panel and a surface of the floor beam, the first and second sealing portions being made of a sealing material; and the conductive portion extends in contact with conductive regions of the bottom surface of the floor panel and the surface of the floor beam and defines an electrical connection therebetween, the conductive portion being more conductive than the first and second sealing portions.

In a particular embodiment, the floor panel and floor beam are connected by fasteners extending through one or both of the first and second sealing portions.

In a particular embodiment, the assembly further comprises an adhesive between the sealing member and the bottom surface of the floor panel, and/or between the sealing member and the surface of the floor beam.

In a particular embodiment of any of the above, the conductive portion has a resistivity of at most 10⁻⁶ Ω·m.

In a particular embodiment of any of the above, the first and second sealing portions have a resistivity of at least 10⁶ Ω·m.

In a particular embodiment of any of the above, the conductive portion and the first and second side portions include a common base material. The conductive portion may include conductive fillers within the base material that form a conductive path between contact surfaces of the conductive portion. The conductive fillers may include at least one of a mesh material, fibers, nanoparticles and powders.

In a particular embodiment of any of the above, the conductive portion includes metal.

### BRIEF DESCRIPTION OF THE DRAWINGS

Reference is now made to the accompanying figures in which:
Fig. 1 is a schematic tridimensional view of an aircraft;
Fig. 2 is a schematic cross-sectional view of the fuselage of an aircraft such as shown in Fig. 1;
Fig. 3 is a schematic top plan view of a floor panel attached to a floor beam with a conductive sealing member therebetween, in accordance with a particular embodiment;
Fig. 4 is a schematic cross-sectional view of the panel, beam and conductive sealing member of Fig. 3, in accordance with a particular embodiment; and
Fig. 5 is a schematic top plan view of a conductive sealant, in accordance with a particular embodiment.

### DETAILED DESCRIPTION

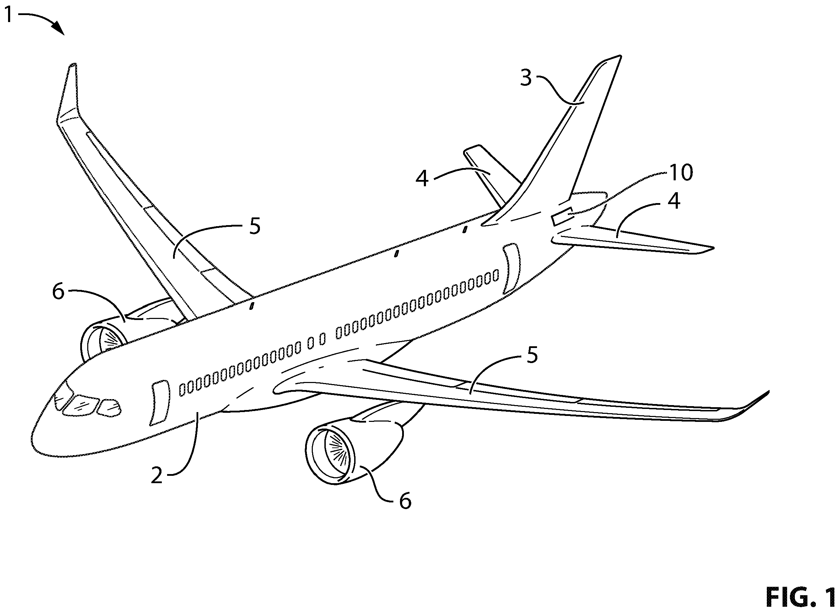

Referring to the drawings and more particularly to Fig. 1, an aircraft is shown at 1, and is generally described to illustrate some components for reference purposes in the present disclosure. The aircraft 1 has a fuselage 2 having a fore end at which a cockpit is located, and an aft end supporting a tail assembly, with the cabin generally located between the cockpit and the tail assembly. The tail assembly comprises a vertical stabilizer 3 with a rudder, and horizontal stabilizers 4 with elevators. The tail assembly has a fuselage-mounted tail, but other configurations may also be used for the aircraft 1, such as cruciform, T-tail, etc. Wings 5 project laterally from the fuselage. The aircraft 1 has engines 6 supported by the wings 5, although the engines 6 could also be mounted to the fuselage 2. The aircraft 1 is shown as a jet-engine aircraft, but may also be a propeller aircraft.

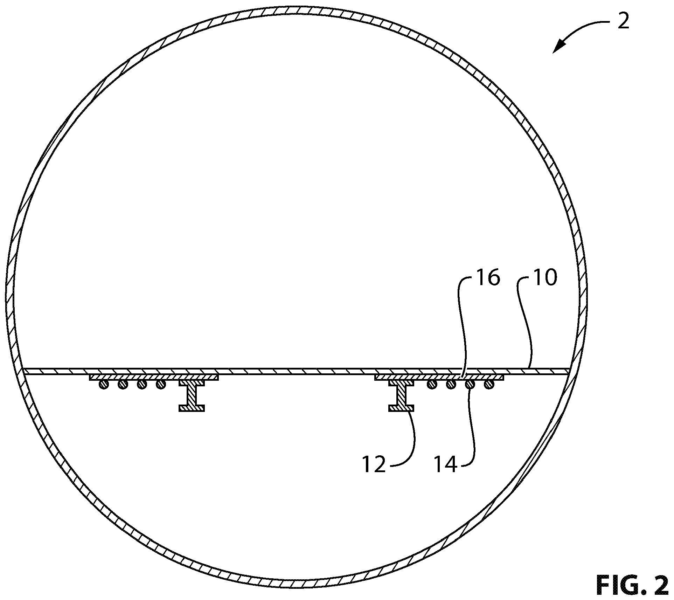

Fig. 2 is a schematic cross-section of the aircraft fuselage 2. The floor includes a plurality of floor panels 10 supported by floor beams 12, which are spaced from one another and extend along the longitudinal axis of the aircraft 1. Cross beams (not shown) extend laterally between the sides of the fuselage 2 and connect the floor beams 12 together to form a checkerboard lattice under the floor within the cabin of the aircraft 1.

The aircraft 1 includes wire bundles 14, for example to transfer power to one or more of the operational components within the aircraft 1, to transmit electrical signals that are processed by one or more of the devices on the aircraft 1, etc. It is desirable to provide shielding so that the wires in the wire bundles 14 are insulated (or isolated) from EM and RF influences, which may impact upon the performance and/or operation of the wires in the wire bundles 14 in addition to interfering with one or more components on board the aircraft 1.

The floor beams 12 are conductive, for example made from metal such as aluminum or an aluminum alloy, and provide some degree of grounding and protection against EM and RF interference. To provide protection to the wire bundles 14 that are spaced from the floor beams 12 at a distance greater than the protective distance established by the floor beams 12, the aircraft 1 includes ground planes 16 that are positioned beneath the floor, for example forming the bottom surface of the floor panels 10, positioned above and adjacent to the wire bundles 14. The ground planes 16 are made from a conductive material, for example made from metal such as aluminum or an aluminum alloy. The wire bundles 14 are positioned sufficiently close to the ground planes 16 so that they benefit from the electrical protection established by the ground planes 16. The ground planes 16 may define part or the entire bottom surface of the floor panels 10.

In a particular embodiment, the floor panels 10 are removably connected to the floor beams 12, thereby providing access to the wire bundles 14 positioned thereunder.

In a particular embodiment, the floor panels 10 are made of material having a relatively low conductivity when compared to metal, for example composite material, and the ground plane 16 at the bottom surface of each panel 10 is formed by a thin layer of conductive material (for example, with a thickness of approximately 0.01 inch or 0.254 mm; a thicker or thinner ground plane is also possible) and may include a plurality of holes cut therethrough. The presence of holes within the ground plane 16 may help to reduce the weight of the aircraft 1. Alternately, each ground plane 16 may be continuous as shown, i.e. without any holes defined therein; such a configuration may help to improve the shielding protection provided to the adjacent wire bundles 14. In a particular embodiment, each ground plane 16 is provided in the form of a metal foil affixed to the floor panel 10 to define the bottom surface thereof.

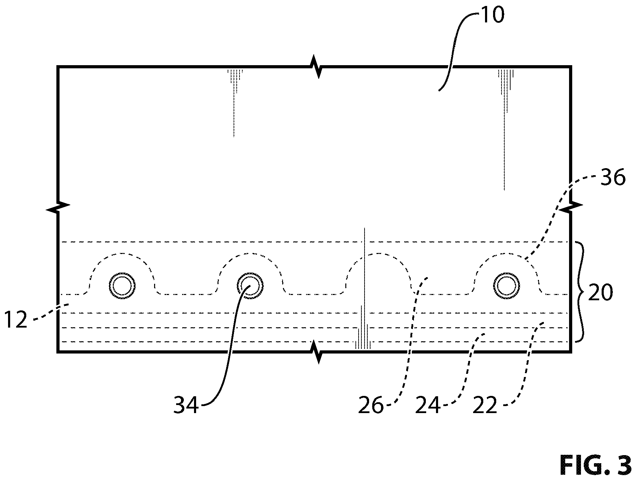

Conduction is required between the bottom surface (ground plane 16) of the floor panel 10 and the contacting surface of the floor beam 12, to provide for proper shielding of the adjacent wire bundles 14. Moreover, metal to metal interfaces need to be sealed from moisture (spilled liquids, condensation, etc.) which could promote corrosion at the interface. The connection between the floor panel ground plane 16 and the floor beam 12 is thus sealed by a conductive sealing member 20 received between the floor panel 10 and the floor beam 12, as shown in Figs. 3-4.

Referring to Figs. 3-5, the sealing member 20 includes a conductive portion 22 sandwiched between first and second sealing portions 24, 26. The sealing portions 24, 26 are made of a fluid-tight or sealing material (i.e. material preventing the passing of fluid therethrough), for example a silicon-based material; alternate materials are also possible, including, but not limited to, suitable polymer-based, plastic-based and elastomer-based materials. In a particular embodiment, the two sealing portions 24, 26 are made of different sealing materials from one another. The conductive portion 22 is more conductive than the sealing portions 24, 26, and sufficiently conductive to form an adequate electrical connection between the ground plane 16 and the floor beam 12. The conductive portion 22 can be made of, or can include, for example a suitable metal; alternate materials are also possible. In a particular embodiment, the conductive and sealing portions 22, 24, 26 are made of a common base material having suitable sealing properties, for example a silicon-based sealing material, and the conductive portion 22 further includes conductive fillers, for example in the form of conductive mesh, conductive fibers, conductive nanoparticles or conductive powder.

In a particular embodiment, the conductive portion 22 has a resistivity of at most 10⁻⁶ Ω·m. In a particular embodiment, the sealing portions 24, 26 are considered to be non-conductive, with a resistivity of at least 10⁶ Ω̇·m.

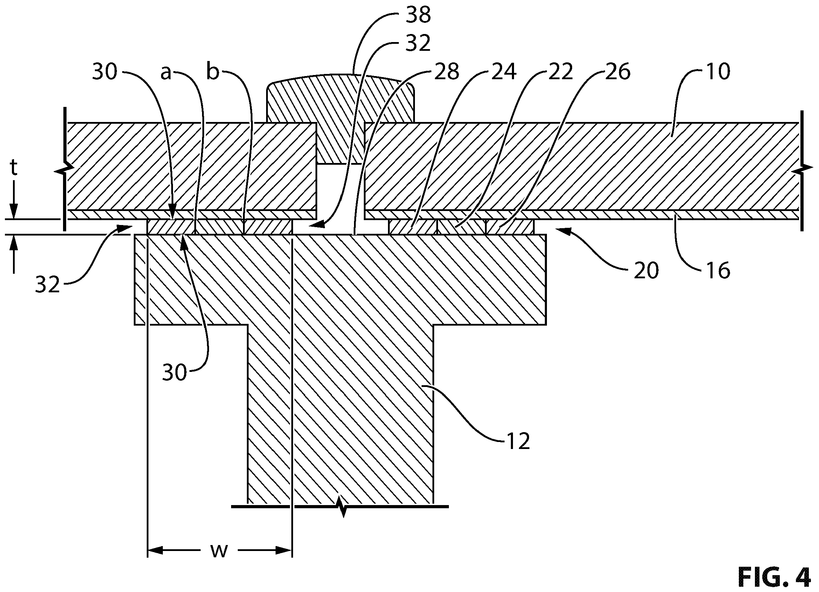

Referring particularly to Fig. 4, the sealing portions 24, 26 extend between and in contact with facing surfaces of both the ground plane 16 and the top surface 28 of the floor beam 12, to prevent moisture from reaching the conductive portion 22. The conductive portion 22 extends between and in contact with the ground plane 16 and the top surface 28 of the floor beam 12, to define the electrical connection therebetween. It is understood that the facing surfaces of the ground plane 16 and of the floor beam 12 contacting the sealing member 20 are conductive at least along the region contacting the conductive portion 22 of the sealing member 20. In a particular embodiment, the floor beam 12 is treated to remove any coating/paint from the top surface 22, at least along the region thereof which will contact the conductive portion 22. Accordingly, the ground plane 16 is suitably grounded via the network of supports defined by the floor beams 12 and the cross beams (among other components in the aircraft 1).

It is understood that the facing surfaces contacting the sealing member 20 may also be conductive in the regions contacting the sealing portions 24, 26; alternately, one or both of the facing surfaces may be non-conductive or less conductive (e.g. coated, painted) in the regions contacting the sealing portions 24, 26, as long as both facing surfaces are conductive in the region contacting the conductive portion to ensure conduction therebetween.

In a particular embodiment, abutting sealing members 20 are provided in contact with the ground plane 16 to form a closed perimeter around the entire periphery of each floor panel 10, along the connections to the floor beams 12 and cross-beams supporting the floor panel 10. Each floor panel 10 is thus connected to its supporting structure in a fluid-tight matter. Sealing members 20 may also overlap at junctions between floor beams 12 and cross-beams.

As can be seen more clearly in Fig. 4, the sealing member 20 shown thus has a body with two opposed contact surfaces 30, for contacting the facing surfaces of the connected elements defining the connection to be sealed. The sealing member 20 also includes opposed side surfaces 32 extending between and interconnecting the contact surfaces 30. The conductive portion 22 extends across the thickness t of the body to define part of each of its contact surfaces 30, and extends along the width w of the body between two locations a, *b* inwardly spaced from the side surfaces 32. In embodiments where conduction is provided through fillers, the fillers are configured and disposed to define conductive path(s) between the contact surfaces 30.

In use, the side surfaces 32 are susceptible to being exposed to moisture. The two sealing portions 24, 26 thus each define one of the side surfaces 32 of the body, and extend along the width w of the body from the respective side surface 32 to the conductive portion 22, so that the sealing portions 24, 26 insulate the conductive portion 22 from moisture contacting the side surfaces 32. The sealing portions 24, 26 also extend across the thickness t of the body and define the contact surfaces 30 between the respective side surface 32 and the conductive portion 22, so that the sealing portions 24, 26 act to prevent moisture from reaching the part of the contact surfaces 30 defined by the conductive portion 22. The interface between the facing surfaces of the connected elements and the conductive portion 22 is thus sealed on each side by the sealing portions 24, 26.

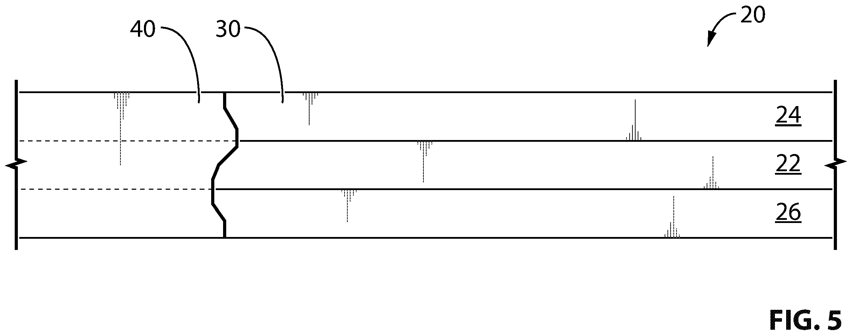

The conductive portion 22 may be centered with respect to the width w of the body, such that both sealing portions 24, 26 have a same dimension along the width w of the body (see Fig. 4) or alternately, the conductive portion 22 may be defined closer to one of the side surfaces 32 than to the other, so that one of the sealing portions 24 has a greater dimension along the width w of the body than the other sealing portion 26 (see Figs. 3 and 5). The conductive portion 22 may be provided as a continuous line as shown, or in a plurality of spaced apart segments (e.g. dotted line) each forming a respective part of the two opposed contact surfaces 30, and each spaced from the side surfaces 32 by the sealing portions 24, 26. The configuration of the conductive portion 22 is selected so that the total area of the part(s) of the contact surfaces 30 defined by the conductive portion 22 and in contact with conductive regions of the facing surfaces is sufficient to fulfill the grounding need of the particular application, based on the level of current that is expected to circulate between the elements electrically connected through the sealing member 20, and on the conductivity of the conductive portion 22. Determination of the sufficient contact area is within the skill of the person of the art and will not be described therein.

In a particular embodiment, one or both of the contact surfaces 30 of the sealing member 20 may be covered by an adhesive releasably engaged to a respective backing paper 40 covering the contact surface(s) 30, such that the sealing member 20 is provided in a ready-to-apply tape form. In another embodiment, the material of the sealing member 20 itself includes adhesive properties, such that the contact surfaces 30 are adhesive without the need to apply a separate adhesive material thereto. The backing paper 40 is removed and the adhesive covered surface(s) 30 of the sealing member 20 can be engaged to an element to be sealed.

In a particular embodiment and with reference to Fig. 3, the floor panel 10 and floor beams 12 are interconnected by removable fasteners 34 extending through one or both of the sealing portions 24, 26. In a particular embodiment, the sealing portion(s) 24, 26 is/are not predrilled prior to the insertion of the fasteners 34, so that the sealing material of the sealing portion(s) 24, 26 may be more closely engaged to the fasteners 34, to reduce the risks of leaks through the fastener holes. In the embodiment shown, the floor beam 12 includes protuberances 36 for receiving the fasteners 34; other configurations are also possible, including, but not limited to, a floor beam having a constant cross-section along its length. In a particular embodiment, the fasteners 34 may extend through the conductive portion 22 as well.

In a particular embodiment and with reference to Fig. 4, additional sealing material 38 may be provided between the top surfaces of adjacent ones of the floor panels 10, to reduce the risk of moisture above the floor panels 10 reaching the connection between the floor panel 10 and floor beam 12.

Although the sealing member 20 has been described as used in the connection between floor panels 10 and floor beams 12, it can also be used in any connection between components having conductive (e.g. metal) surfaces that need to be in electrical contact with one another, with the conductive interface requiring sealing from the environment. Examples of such alternate applications, which are not covered by the present invention, include, but are not limited to, the sealing of antennas connected to the fuselage, access panels on the fuselage or on the wings, shelves in avionics bays, and any connection of elements where conductivity is required therebetween for grounding or lightning strike protection. The sealing member 20 may be particularly, although not exclusively, adapted for sealing assemblies where one or the two components need to be removable.

Although the sealing member 20 has been depicted with an elongated rectangular body, it is understood that a variety of alternate shapes are also possible, depending on the shape of the conductive surfaces that need to be in electrical contact with one another and sealed from the environment. The sealing portions and conductive portion may thus have various shapes, with the sealing portions extending between exposed side surfaces of the sealing member and the conductive portion to prevent moisture in contact with the exposed side surfaces from reaching the conductive portion.

Modifications and improvements to the above-described embodiments of the present invention may become apparent to those skilled in the art. The foregoing description is intended to be exemplary rather than limiting. The scope of the present invention is therefore intended to be limited solely by the scope of the appended claims.

## Claims

1. A grounded floor assembly for an aircraft, the assembly comprising:
a floor panel (10) having a bottom surface;
a conductive floor beam (12) supporting and connected to the floor panel (10);
a sealing member (20) between the floor panel (10) and the floor beam (12), the sealing member (20) including a conductive portion (22) sandwiched between first and second sealing portions (24,26); wherein:
the first and second sealing portions (24,26) extend between and in contact with the bottom surface of the floor panel (10) and a surface of the floor beam (12), the first and second sealing portions (24,26) being made of a sealing material; and
the conductive portion (22) extends in contact with conductive regions of the bottom surface of the floor panel (10) and the surface of the floor beam (12) and defines an electrical connection therebetween, the conductive portion (22) being more conductive than the first and second sealing portions (24,26).

2. The assembly as defined in claim 1, wherein the floor panel (10) and floor beam (12) are connected by fasteners (34) extending through one or both of the first and second sealing portions (24,26).

3. The assembly as defined in claim 1, wherein the conductive portion (22) has a resistivity of at most 10⁻⁶ Ω·m.

4. The assembly as defined in claim 3, wherein the first and second sealing portions (24,26) have a resistivity of at least 10⁶ Ω·m.

5. The assembly as defined in claim 1, wherein the conductive portion (22) and the first and second sealing portions (24,26) include a common base material

6. The assembly as defined in claim 5, wherein the conductive portion (22) includes conductive fillers within the base material that form a conductive path between the bottom surface of the floor panel (10) and the surface of the floor beam (12).

7. The assembly as defined in claim 6, wherein the conductive fillers include at least one of a mesh material, fibers, nanoparticles and powders.

8. The assembly as defined in claim 1, wherein the conductive portion (22) includes metal.

9. The assembly as defined in claim 1, further comprising an adhesive between the sealing member (20) and the bottom surface of the floor panel (10) and/or between the sealing member (20) and the surface of the floor beam (12).

## Patentansprüche

1. Geerdete Bodenanordnung für ein Flugzeug, wobei die Anordnung umfasst:
eine Bodenplatte (10) mit einer Bodenfläche;
einen leitenden Bodenträger (12), der die Bodenplatte (10) trägt und mit ihr verbunden ist; ein Dichtungselement (20) zwischen der Bodenplatte (10) und dem Bodenträger (12), wobei das Dichtungselement (20) einen leitenden Abschnitt (22) enthält, der zwischen ersten und zweiten Dichtungsabschnitten (24, 26) angeordnet ist; wobei:
sich die ersten und zweiten Dichtungsabschnitte (24, 26) zwischen und in Kontakt mit der Bodenfläche der Bodenplatte (10) und einer Oberfläche des Bodenträgers (12) erstrecken, wobei die ersten und zweiten Dichtungsabschnitte (24, 26) aus einem dichtenden Material hergestellt sind;
und sich der leitende Abschnitt (22) in Kontakt mit leitenden Regionen der Bodenfläche der Bodenplatte (10) und der Oberfläche des Bodenträgers (12) erstreckt und eine elektrische Verbindung dazwischen definiert, wobei der leitende Abschnitt (22) leitender als die ersten und zweiten Dichtungsabschnitte (24, 26) ist.

2. Anordnung nach Anspruch 1, wobei die Bodenplatte (10) und der Bodenträger (12) durch Befestiger (34) verbunden sind, die sich durch einen oder beide der ersten und zweiten Dichtungsabschnitte (24, 26) erstrecken.

3. Anordnung nach Anspruch 1, wobei der leitende Abschnitt (22) einen Widerstand von höchstens 10⁻⁶ Ω·m aufweist.

4. Anordnung nach Anspruch 3, wobei die ersten und zweiten Dichtungsabschnitte (24, 26) einen Widerstand von mindestens 10⁶ Ω·m aufweist.

5. Anordnung nach Anspruch 1, wobei der leitende Abschnitt (22) und die ersten und zweiten Dichtungsabschnitte (24, 26) ein gemeinsames Basismaterial enthalten.

6. Anordnung nach Anspruch 5, wobei der leitende Abschnitt (22) leitende Füllmaterialien im Basismaterial enthält, die einen leitenden Pfad zwischen der Bodenfläche der Bodenplatte (10) und der Oberfläche des Bodenträgers (12) formen.

7. Anordnung nach Anspruch 6, wobei die leitenden Füllmaterialien mindestens eines aus einem Netzmaterial, Fasern, Nanopartikeln und Pulvern enthalten.

8. Anordnung nach Anspruch 1, wobei der leitende Abschnitt (22) Metall enthält.

9. Anordnung nach Anspruch 1, ferner umfassend einen Klebstoff zwischen dem Dichtungselement (20) und der Bodenfläche der Bodenplatte (10) und/oder zwischen dem Dichtungselement (20) und der Oberfläche des Bodenträgers (12).

## Revendications

1. Ensemble de plancher mis à la terre pour un aéronef, l'ensemble comprenant :
un panneau de plancher (10) possédant une surface inférieure ;
une poutre de plancher conductrice (12) supportant le panneau de plancher (10) et étant raccordée à celui-ci ; un élément d'étanchéité (20) entre le panneau de plancher (10) et la poutre de plancher (12), l'élément d'étanchéité (20) comprenant une partie conductrice (22) intercalée entre des première et seconde parties d'étanchéité (24, 26) ;
lesdites première et seconde parties d'étanchéité (24, 26) s'étendant entre la surface inférieure du panneau de plancher (10) et une surface de la poutre de plancher (12) et étant en contact avec celles-ci, lesdites première et seconde parties d'étanchéité (24, 26) étant constituées d'un matériau d'étanchéité ;
et ladite partie conductrice (22) s'étendant en contact avec des zones conductrices de la surface inférieure du panneau de plancher (10) et de la surface de la poutre de plancher (12) et définissant un raccord électrique entre elles, la partie conductrice (22) étant plus conductrice que les première et seconde parties d'étanchéité (24, 26).

2. Ensemble selon la revendication 1, ledit panneau de plancher (10) et ladite poutre de plancher (12) étant raccordées par des éléments de fixations (34) s'étendant à travers la première et/ou la seconde partie d'étanchéité (24, 26).

3. Ensemble selon la revendication 1, ladite partie conductrice (22) possédant une résistivité inférieure ou égale à 10⁻⁶ Ω̇·m.

4. Ensemble selon la revendication 3, lesdites première et seconde parties d'étanchéité (24, 26) possédant une résistivité supérieure ou égale à 10⁶ Ω̇·m.

5. Ensemble selon la revendication 1, ladite partie conductrice (22) et lesdites première et seconde parties d'étanchéité (24, 26) comprenant un matériau de base commun.

6. Ensemble selon la revendication 5, ladite partie conductrice (22) comprenant des charges conductrices dans le matériau de base qui forment un chemin conducteur entre la surface inférieure du panneau de plancher (10) et la surface de la poutre de plancher (12).

7. Ensemble selon la revendication 6, lesdites charges conductrices comprenant au moins l'un d'un matériau à mailles, de fibres, de nanoparticules et de poudres.

8. Ensemble selon la revendication 1, ladite partie conductrice (22) comprenant du métal.

9. Ensemble selon la revendication 1, comprenant en outre un adhésif entre l'élément d'étanchéité (20) et la surface inférieure du panneau de plancher (10) et/ou entre l'élément d'étanchéité (20) et la surface de la poutre de plancher (12).
